Europäisches Patentamt

European Patent Office

Office européen des brevets

(19)

(11) **EP 1 391 756 A1**

(12) **EUROPEAN PATENT APPLICATION**

(43) Date of publication:
**25.02.2004 Bulletin 2004/09**

(51) Int Cl.7: **G02B 6/12**, H01S 5/0625

(21) Application number: **02255800.1**

(22) Date of filing: **20.08.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(71) Applicant: **Agilent Technologies, Inc. - a Delaware corporation -**
**Palo Alto, CA 94303-0870 (US)**

(72) Inventors:
• **Charles, Paul**
  **Ipswich, Suffolk IP8 4AD (GB)**

• **Paoletti, Roberto**
  **10060 Airasca (TO) (IT)**
• **Agresti, Michele**
  **10144 Torino (IT)**
• **Vallone, Marco**
  **10142 Torino (IT)**

(74) Representative: **Coker, David Graeme et al**
  **Agilent Technologies UK Ltd,**
  **Legal Dept,**
  **Eskdale Road,**
  **Winnersh Triangle**
  **Wokingham, Berks RG41 5DZ (GB)**

(54) **Wavelength-selective distributed Bragg reflector device**

(57)     The present invention relates to a wavelength-selective distributed Bragg reflector (DBR) device (5) which may be used in wavelength-selective optoelectronic devices (1) such as a tuneable semiconductor laser device or a tuneable wavelength-selective receiver. The device (1) comprises a semiconductor substrate and a plurality of semiconductor layers deposited upon the substrate that form a plurality of adjacent distributed Bragg reflector (DBR) components (5A-D). Each DBR component (5A-D) has: an elongate optical waveguide (11A-D) for carrying optical radiation (27), each waveguide (11A-D) being spaced laterally from adjacent waveguides with respect to the length of each waveguide (11A-D); and a DBR grating for selecting the wavelength ($\lambda_{A-D}$) of the optical radiation (27) carried by the waveguide (11A-D), the grating having along the length of the waveguide a grating pattern (38) of alternating strips of varying refractive index, each strip extending at a transverse angle ($\beta$) to the length of the waveguide (11A-D), and the strips of each grating pattern (38) being aligned with corresponding strips in each adjacent component. The strips of the DBR components (5A-D) extend at different transverse angles ($\beta_{A-D}$) to corresponding strips in other DBR components (5A-D) so that the DBR gratings of different DBR components (5A-D) select different wavelengths ($\lambda_{A-D}$).

*Fig. 1*

**Description**

The present invention relates to a wavelength-selective distributed Bragg reflector (DBR) device which may be used in wavelength-selective optoelectronic devices such as a tuneable semiconductor laser device or a tuneable wavelength-selective receiver.

Tuneable optoelectronic devices are useful in many applications, for example in optical fibre networks using wavelength division multiplexing (WDM). Such networks may use a central, temperature controlled and wavelength-stabilised optical source that generates laser radiation at a plurality of different wavelengths. Such optical systems are expensive, and often need to be located in a well maintained central office of the network.

There is an increasing need for lower cost multi-wavelength optical sources and receivers that may be distributed around a WDM network. Such WDM networks usually operate within a 100 nm wide spectrum around 1550 nm. One way of stabilising the wavelength of an optical source is to combine the source with an electronically controllable DBR component through which an electric current may be passed in order to tune the wavelength of the source. Typically the wavelength can be tuned by 10 nm above a base wavelength determined by the grating pitch of the DBR. A plurality of such devices, each with a different grating pitch can then be used to cover a wider range of operating wavelengths.

Such a system leads to other problems, particularly if the system is not contained in a central office. For example, it may be necessary to replace or change a tuneable optoelectronic device, either to change the range over which the wavelength may be varied, or if the device becomes faulty. It may then be necessary to hold a stock of a large number of different such devices in order to cover the full wavelength operating range of the complete system.

One way of dealing with this problem is to provide a widely tuneable optoelectronic device having a tuning range of about 40 nm. This can be done by using complex grating technology, for example sampled grating or superstructure grating technology. These devices incorporate short sub-sections of grating as reflectors. By choosing a slightly different sampling period for each reflector a wide tuning range can be obtained through the vernier effect. As this device is a four section device characterisation can be a major issue. Another way to make a widely tuneable optoelectronic device is to form a monolithically integrated or a hybrid device having many fixed or tuneable solid state lasers each with a separately formed DFB or device having a different grating pitch. However, such widely tuneable devices tend to be expensive and not suited to many applications.

It is an object of the invention to provide a more convenient wavelength-selective DBR device.

According to the invention, there is provided a wavelength-selective optoelectronic device comprising a semiconductor substrate and a plurality of semiconductor layers deposited upon the substrate that form a plurality of adjacent distributed Bragg reflector (DBR) components, each DBR component having: an elongate optical waveguide for carrying optical radiation, each waveguide being spaced laterally from adjacent waveguides with respect to the length of each waveguide; and a DBR grating for selecting the wavelength of the optical radiation carried by the waveguide, the grating having along the length of the waveguide a grating pattern of alternating strips of varying refractive index, each strip extending at a transverse angle to the length of the waveguide, and the strips of each grating pattern being aligned with corresponding strips in each adjacent component; in which the strips of the DBR components extend at different transverse angles to corresponding strips in other DBR components so that the DBR gratings of different DBR components select different wavelengths.

In general, it will be easier to provide a grating pattern in which the strips of adjacent waveguides are aligned. For example, the grating may be formed in a single process step using two-beam holographic definition of a pattern that extends across all DBR areas of a semiconductor wafer or chip on which the waveguides are subsequently defined. The relative angle of the pattern and each waveguide then determines an effective grating pitch of the pattern for each particular DBR component, and hence the wavelength selected by the interaction of the waveguide and DRB grating. The effective pitch and hence selected wavelength is then a minimum when the grating crosses the waveguide at right angles, and increases as the angle between the grating and waveguide deviates from a right angle.

In a preferred embodiment of the invention, the device comprises at least one electrical connection by which an electrical current may be supplied to the DBR component in order to tune the selected wavelength. The tuning may be by way of an opto-electronic interaction with the materials using DBR grating and/or the waveguide, for example changing the refractive index of the waveguide, and hence the effective pitch of the grating for optical radiation guided within the waveguide.

To provide a full range of selected wavelengths, it is preferred if the transverse angle for the strips of at least one DBR component is a right angle.

There are a number of different types of orientation in which the relative angle between the aligned strips and the waveguide can be made to vary between DBR components. In one embodiment of the invention, the waveguides are substantially straight. The strips of each grating pattern may also be aligned substantially parallel with the strips of other grating patterns. Then, each substantially straight waveguide is set at an angle to the other waveguides.

However, it may be that strips for each DBR component, while aligned with strips of other DBR components, are curved and concentric. The waveguides may then each be parallel with each other, but cross through the aligned strips in such a way the concentric strips cross each waveguide at different angles. The effective pitch of the strips then increases for those strips that cross a waveguide at other than right angles. Therefore, it may be that the waveguide of each DBR component is substantially parallel with the waveguides of other DBR components.

The device may be incorporated in an optical receiver or transmitter device. For example, the wavelengths selected could be those received from a WDM network in which a plurality of wavelengths may be used to transmit information. Each DBR component may then be tapped or otherwise connected to the WDM network to select and receive optical radiation having a particular wavelength, and to pass such optical radiation to an optical receiver. The receiver may be a photo-detector integrated in the same substrate as the WDM component.

In a preferred embodiment of the invention, the semiconductor substrate and a plurality of semiconductor layers deposited upon the substrate form additionally at least one semiconductor laser device for generating optical radiation. The, or each, laser device is then optically coupled with a corresponding DBR component that selects the wavelength of said laser device. The DBR device may then also help to stabilise the wavelength about a constant desired wavelength.

If there is a plurality of such laser devices optically coupled with corresponding DBR components, then it becomes possible to provide a convenient multi-wavelength optical source. If each DBR component is tuneable, then such a source may be able to provide tuneable optical radiation over an extended range. For example, a device with four lasers and associated DBR components may be able to provide tuneable optical radiation over a 40 nm range about 1550 nm.

The semiconductor substrate and a plurality of semiconductor layers deposited upon the substrate may form additionally an optical coupler for coupling together optical radiation entering and/or leaving the optical waveguides. This is useful if the device is to be connected to a single optical input or output, for example an optical fibre.

Also according to the invention, there is provided a method of forming a wavelength-tuneable optoelectronic device comprising a semiconductor substrate and a plurality of semiconductor layers deposited upon the substrate, comprising the steps of:

i) growing on the semiconductor substrate a plurality of semiconductor layers, including at least one layer forming an optical channel for conveying optical radiation;

ii) creating in at least one layer a distributed Bragg reflector (DBR) pattern having alternating strips of varying refractive index for selecting the wavelength of optical radiation conveyed in said channel;

iii) defining in said optical channel a plurality of elongate optical waveguides for guiding optical radiation, each waveguide being spaced laterally from adjacent waveguides with respect to the length of each waveguide; wherein

the waveguides and DBR pattern are formed so that the strips cross different waveguides at different angles, so that the strips select different wavelengths in different waveguides.

The invention will now be further described by way of example, and with reference to the accompanying drawings, in which:

Figure 1 is a schematic plan view of a wavelength-selective optoelectronic device according to the invention, having four laser diodes each of which is optically coupled to one of four DBR components each of which includes an optical waveguide set at various angles to a common DBR grating pattern;

Figure 2 is a transverse cross-section through one of the laser diodes taken along line II-II of Figure 1; and

Figure 3 is a longitudinal cross-section through one of the DBR components taken along line III-III of Figure 1.

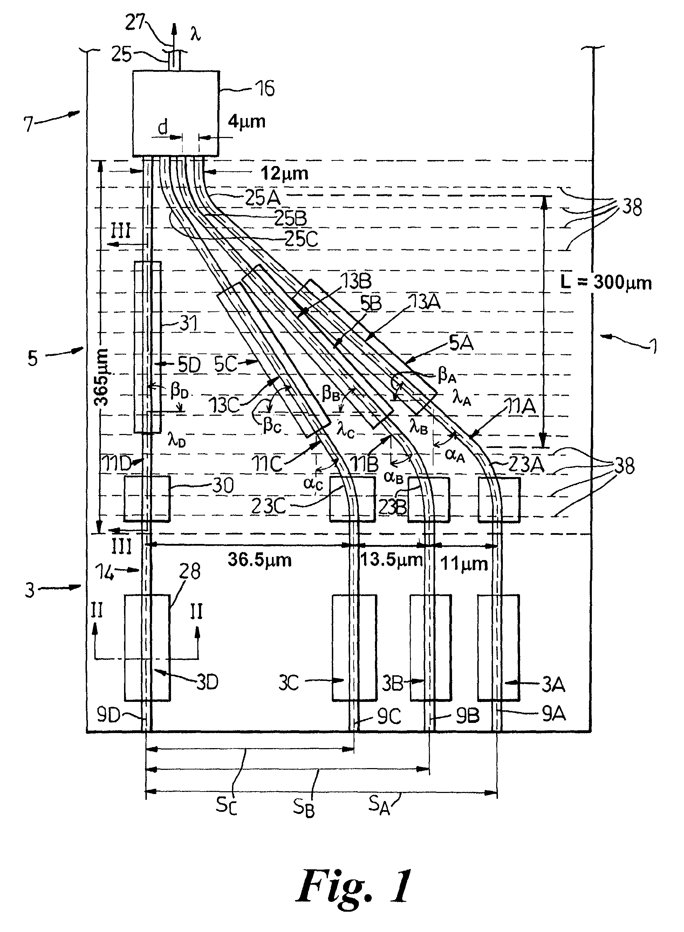

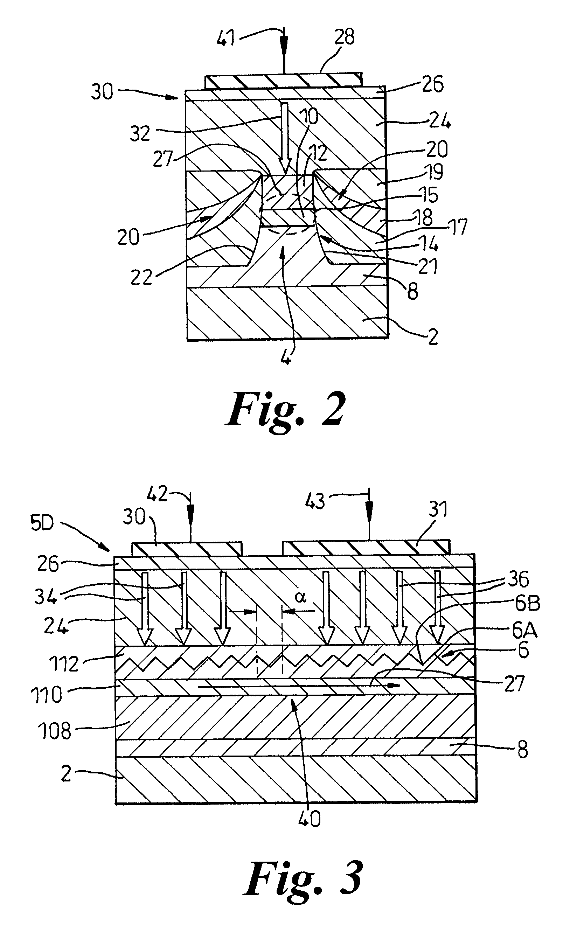

Figure 1 shows schematically a plan view of a wavelength-selective optoelectronic device 1. The device 1 has a laser diode section 3 with four similar or identical laser diodes 3A,3B,3C,3D, a DBR component section 5 having four DBR components 5A,5B,5C,5D, and a coupler section 7. The structure of one of the laser diodes 3D is shown in more detail in Figure 2, and the structure of one of the DBR components 5D is shown in more detail in Figure 3. The three sections 3,5,7 of the device are all fabricated by depositing semiconductor layers on a common III-V substrate 2.

Each of the laser diodes 3A-D includes a buried heterojunction mesa stripe 14. Each mesa stripe 14 has a straight optical axis 9A-D along which optical radiation 27 generated by the laser diode 3A-D is guided towards the DBR section 5. Each of the DBR components 5A-D also has a buried mesa waveguide 11A-D. One of the mesa waveguides 11D is straight, and the other three mesa waveguides 11A-C are S-shaped, with a central straight section 13A,13B,13C that is bounded by two oppositely curved sections 23A,23B,23C and 25A,25B,25C. The curved waveguide sections 23A-C nearest the laser diode section 3 turn to be parallel with each other and are aligned with the optical axes 9A-C of three corresponding straight mesa stripes 14, whilst the straight waveguide 11D is aligned with the optical axis 9D of the remaining mesa stripe 14.

Each straight section 11A-C is substantially longer than the combined lengths of the adjacent curved sections 23A-C,25A-C and so each of the waveguides 5A-C is substantially straight.

In the laser diode section 3, each of the four axes 9A-D of the mesa stripes 14 is parallel and laterally adjacent to the other axes 9A-D of the mesa stripes. In the DBR section 5, each of the four waveguide straight sections 13A-C, 11D is non-parallel and laterally adjacent to the other waveguide straight sections 13A-C,11D, so that the waveguides 11A-D diverge towards the laser diode section 3 and converge towards the coupler section 7.

The curved waveguide sections 25A-C nearest the coupler section 7 converge to be parallel with the straight DBR waveguide 11D in such a way that all four waveguides 11A-D are parallel and also equally spaced with respect each other as they enter a multi-mode interference (MMI) coupler 16 in the coupler section 7. The MMI coupler 16 has a single output waveguide 25 into which all four DBR waveguides 11A-D are coupled.

The structure of the device 1 will now be described with reference particularly to Figures 2 and 3.

Figure 2 shows schematically and not to scale, a transverse cross-section through the laser diode 3D. The laser 3D includes the buried mesa heterostructure 14 of the type suitable for use as a transmitter in a fibre-optic link operating between 1.27 and 1.6 $\mu$m.

Figure 3 shows schematically and not to scale, a longitudinal cross-section through the DBR component 5D. The DBR component includes the buried waveguide structure 11D and a DBR grating 6 suitable for stabilising and tuning the wavelength $\lambda$ of optical radiation 27 generated by the laser diode 3D.

The device 1 is formed starting from a wafer that is around 50 mm in diameter, and that has an n-InP substrate 2 doped to around $10^{19}$ cc$^{-1}$, on which is grown a number of n-type and p-type III-V semiconductor layers, using well-known MOCVD techniques. The p-type dopant is zinc, and the n-type dopant is sulphur.

The first grown layer is a 2 $\mu$m thick n$^-$-InP buffer layer 8 doped to around $10^{18}$ cc$^{-1}$. An active layer 10 is grown on the buffer layer 8 according to known techniques for fabricating planar active lasers for a laser diode - the active layer could be a bulk region or a strained multiple quantum well (SMQW) structure. An example of an SMQW device is discussed in W. S. Ring et al, Optical Fibre Conference, Vol. 2, 1996 Technical Digest Series, Optical Society of America.

In the present example, the laser device 1 has a quaternary $In_xGa_{1-x}As_{1-y}P_y$ active layer 10 that may be between about 100 nm to 300 nm thick. The active layer 10 is topped by a cladding layer 12, formed from p$^+$-InP, grown to be between about 100 nm to 1 $\mu$m thick.

After the deposition of the cladding layer 12, the device is photolithographically patterned with a photoresist to leave a patterned oxide mask (not shown) that protectively covers just the laser section 3. The deposited semiconductor layers are then etched to remove, in the areas 5,7 not covered by the patterned mask, the cladding layer 12, the active layer 10, and part of the buffer layer 8.

A number of semiconductor layers are then grown across the DBR section and coupler section 7 as follows. First, a 200 nm thick n$^-$-InP buffer layer 108 doped to around $10^{18}$ cc$^{-1}$ is grown on the remaining buffer layer 8. A waveguide layer 110 is grown on the buffer layer 108 according to known techniques for fabricating waveguide lasers for a DBR component - the waveguide layer could be, for example bulk InGaAsP of composition wavelength 1420-1480nm. An example of a suitable waveguide layer 110 is discussed in F. Delorme, `Butt-jointed laser with 15 nm tunability grown in three MOVPE steps', Electron Lett., 1995, 31, (15) pp 1244-1245.

In the present example, the waveguide layer has a quaternary $In_xGa_{1-x}As_{1-y}P_y$ layer 110 of composition 1420 to 1480 nm that may be between about 100 nm to 300 nm thick. The waveguide layer 110 is topped by a DBR grating layer 112, formed from p$^+$-InP, grown to be between about 100 nm to 1 $\mu$m thick.

A DBR grating 6 for the DBR component 5D is contained in the p-InP grating layer 112 by forming alternating layers of high and low refractive index. Alternatively, the DBR grating 6 could be formed in the n-InP buffer layer 108. In either case, the DBR grating 6 interacts optically with optical radiation 27 generated by the active layer 10 to stabilise the wavelength $\lambda$ of the optical radiation 27. As will be explained below, the DBR component can also be used to tune the wavelength $\lambda$ of the optical radiation 27.

One convenient way of forming the DBR element is by using a holographic patterning process in which two interfering beams are used to create in a photoresist covering the device a series of parallel photoresist or dielectric masks having a regular pitch of about 230 to 250 nm. This grating mask is then transferred into the waveguide layer via wet chemical or dry etching of the semiconductor. Subsequent overgrowth of the etched grating structure with a layer of p-InP planarises the surface and produces a DBR grating consisting of a pattern of alternating high and low refractive index strips (6A,6B) that extend transversely across the grating section 5 and at right angles to the optical axes 9A-D of the laser diodes 3A-D. This grating pattern is shown schematically by the parallel dotted lines 38 in Figure 1. The strips (6A,6B) across one DBR component 5A-D are therefore aligned with corresponding strips (6A,6B) in each adjacent component 5A-D.

Furthermore, because the straight sections 13A-C,11D of each of the DBR components 5A-D is set at a different angle with respect to the other DBR components, the strips (6A,6B) cross each DBR component at different transverse angles $\beta_{A-D}$. The result is that the effective pitch $\gamma$ of the grating 6 is different for each DBR component 5A-D along the straight section 13A-D,11D of each component. As will be explained in more detail below, the straight waveguide section 13A-D,11D of each component 5A-D selects the wavelength $\lambda_{A-D}$ of the optical radiation 27 generated by the laser diode 3A-D. Therefore, because the grating pattern 38 creates a different pitch $\gamma$ along the length 13A-D of each waveguide, the different BDR components 5A-D will naturally select four different wavelengths $\lambda_{A-D}$.

The oxide mask defining the laser section is then removed and the wafer photolithographically patterned with a photoresist to leave another patterned mask that protects and defines the four mesa structures 14 and the four DBR waveguides 11A-D. The patterned wafer is then etched to remove in the unprotected areas of the laser section 3 the cladding layer 12, the active layer 10, part of the buffer layer 8, and in the unprotected areas of the DBR section 5 (and in all of the coupler section 7) the DBR layer 112, the waveguide layer 110, part or all of the buffer layer 108, and optionally some of the buffer layer 8.

The four mesa stripes 14 are then each self-aligned with four corresponding waveguide mesas 11A-D, each of which rise above the level of the common substrate 2. Each mesa stripe 14 has left and right opposite side walls 21,22 that together with the buffer layer 8 and the cladding 12 form a current conduction region 4 for an applied current 32 (I), and which have the effect of guiding an optical mode 27 along the active layer 10 within the mesa stripe 14. Although not shown in detail, each waveguide mesa 11A-D has similar side walls that form a current conduction structure 40 for applied currents 34,36, and which have the effect of guiding the optical mode 27 along the waveguide layer 10 in interaction with the DBR grating 6 within the waveguide mesa 11A-D.

The width of each mesa stripe 14 varies depending on the particular device, but for opto-electronic devices such as laser diodes used in optical transmitters, the mesa stripes 14 are usually between 1 $\mu$m and 3 $\mu$m wide. The waveguide mesas 11A-D will each have a similar width. The mesa stripes 14 and the waveguide mesa 11A-D each rise 1 $\mu$m to 2 $\mu$m above the surrounding substrate 2.

A current confinement or blocking structure 20 is then grown on all unmasked areas of the etched device up to approximately the level of the patterned masks (not shown) that cover the four mesa stripes 14 and four waveguide mesas 11A-D. The structure 20 includes a number of layers adjacent the buffers layer 8,108 including a first p-doped InP layer 17 having a dopant concentration about $1\times10^{18}$ cc$^{-1}$ and above this, an n-doped In-P layer having a dopant concentration of at least about $1\times10^{18}$ cc$^{-1}$. The n-doped InP layer 18 preferably has a substantially constant dopant concentration at least as high as the highest dopant concentration in the p-type layer 17.

The thickness of the n-doped layer 18 is about 0.5 $\mu$m and the thickness of the p-doped layer 17 is about 0.4 $\mu$m. These InP layers 17,18 form a p-n junction that in use is reverse biased and hence insulating when the conduction regions 4,40 are forward biased.

A second p-doped InP layer 19 having a dopant concentration about $1\times10^{18}$ cc$^{-1}$ is then grown over the n-doped layer 18 up to approximately the level of the cladding layer 12 and DBR grating layer 112.

After deposition of the semiconductor layers 17,18,19 used to form the current confinement structure 20, the oxide mask is removed with 10:1 buffered HF from the mesa strip 14 to expose again the cladding layer 12. This leaves an etched and coated wafer comprising the substrate 2, the mesa stripe 14 and the current confinement layers 17,18,19 abutting the opposite sides 21,22 of the mesa stripe 14.

An upper cladding layer 24 formed from highly doped p$^+$-InP is then grown above the cladding layer 12, the DBR grating layer 112, and the layers 17,18,19 used to form the current confinement structure 20, up to a thickness of about 1.5 $\mu$m to 3 $\mu$m. The final semiconductor layer is a 100 nm to 200 nm thick ternary cap layer 26 deposited on the upper cladding layer 24. The cap layer 26 is formed from p$^{++}$-GaInAs, very highly doped to greater than $10^{19}$ cc$^{-1}$, in order to provide a good low resistance ohmic contact for electrical connection to the current conduction regions 4,40 of the four mesa stripes 14 and four waveguide mesas 11A-D. As an alternative to a ternary cap layer, it is possible to use a quaternary InGaAsP cap layer, or both InGaAsP and InGaAs layers.

The process described above creates a so-called butt-coupling between each laser diode 3A-D and the corresponding DBR component 5A-D. It is, however, possible to use other techniques, such as selective area growth, to create the device 1.

Metal layers for electrical contact to the buried heterostructure mesas 14 and DBR waveguides 5A-D are then vacuum deposited on the cap layer 26 using well known techniques, followed by a metal wet etch create photolithographically defined areas. The remaining metal areas include one contact pad 28 for each of the laser diodes 3A-D, one above each of the current conduction regions 4, with good ohmic contact through the cap layer 26. The metal areas also include two contact pads 30,31 for each of the DBR components 5A-D, one of which 30 is close to the laser diode section 3, and the other of which 31 extends across most of the straight section 13A-C,11D of the waveguide 5A-D. The DBR contact pad 30 closest to the laser section 3 is used for phase matching in which an applied current 34 may be used to fine tune the device to avoid mode jumps or discontinuities in the spectral tuning response. The other DBR contact pad 31 is used for tuning the wavelength X of the optical radiation 27, in which a current 36 applied through the current conduction region 40 allows in this example the selected wavelength $\lambda_{A-B}$ from each laser diode 3A-D to be tuned over a range $\Delta\lambda = 10$ nm.

Optionally, the device may include electrical isolation trenches (not shown) that have been etched between electrical contact pads in order to provide increased electrical isolation between pads.

The resulting wafer is then thinned to a thickness of about 70 µm to 100 µm in a standard way, in order to assist with cleaving. Standard metal layers are then deposited by sputtering on the rear surface of the wafer, so enabling electrical contact to be made to the n-side of the devices.

The wafer is then inscribed and cleaved in a conventional process first transversely into bars about 1000 µm wide, and then each bar is cleaved into individual devices about 300 µm wide. The resulting cleaved device 1 is about 1000 µm long (i.e. in the direction of the laser mesa axes 9A-D) and about 300 µm wide.

Although not shown, after testing the device 1 may be packaged in an industry standard package, with a single mode optical fibre coupled with a spherical lens to an output facet of the coupler section waveguide 25. Gold bond wires 41,42,43 are then thermal compression bonded onto the metalised contacts 28,30,31 so that the electrical currents 32,34,36 may be applied to power the device 1. In this example, the currents 32,34,36 are applied just to one laser diode and the corresponding DBR component at any one time, so that a single tuneable wavelength X is provided from the MMI coupler 16 at any one time. Alternatively, it may be desired to drive more than one of the laser diode/ DBR component pairs in order to generate a plurality of distinct wavelengths $\lambda_{A-B}$ at the same time.

Example 1

Specific parameters for the dimensions of the device 1 and relative angles of the grating pattern 38 and the waveguide straight sections 13A-C,11D can be derived as follows. If the device 1 is fabricated so that the wavelength of the straight DBR component 5D is 1530 nm and the tuneable range of each DBR component 5A-D is 10 nm, then the desired wavelengths $\lambda$ of the other three DBR components will be 1540 nm, 1550 nm and 1560 nm. This would give full tunability of wavelength $\lambda$ over of a 40 nm wide range between 1530 nm and 1570 nm.

The required effective grating pitch $\gamma$ across the straight portions 11A-C,13D of the waveguides 5A-D is:

$$\gamma_{A-D} = \lambda_{A-D}/4n,$$

where n is the refractive index of each DBR waveguide 110. A typical value for this refractive index would be n = 1.6.

The angle $\alpha$ that results from these required grating pitches is given by:

$$\alpha_{A-C} = \text{arcos } (\gamma A\text{-}C/\gamma D) ,$$

where $\gamma D = \lambda_{D}/4n$.

The centre-to-centre spacing d of the four DBR waveguides 11A-D where these meet the coupler section is d = 4 µm. Considering just the three curved DBR components 5A-C, the extent L of the central straight portions 13A-C taken along direction parallel to the laser diode optical axes 9A-D will typically be about L = 300 µm. The lateral spacing S of the three laser diodes 3A-C associated with the curved DBR components 5A-C from the laser diode associates with the straight DBR component 5D is then given by:

$$S_A = 3d + L\bullet\sin(\alpha_A)$$

$$S_B = 2d + L\bullet\sin(\alpha_B)$$

$$S_C = d + L\bullet\sin(\alpha_C)$$

This results in the following parameters and dimensions for the device 1:

Table 1:

| Device | Wavelength X in nm | Strip spacing $\gamma$ in nm | Angle $\alpha$ in degrees | Spacing S in nm , |
|---|---|---|---|---|
| A. | 1560 | 11.25 | 58.5 | 71 |

Table 1:   (continued)

| Device | Wavelength X in nm | Strip spacing $\gamma$ in nm | Angle $\alpha$ in degrees | Spacing S in nm , |
|---|---|---|---|---|
| B | 1550 | 9.21 | 48 | 56 |
| C | 1540 | 6.53 | 34.1 | 38 |
| D | 1530 | 0 | 0 | 0 |

The device 1 described above includes a convenient wavelength-selective DBR device 5, which when combined with suitable laser diode sources 3 allows the device 1 to produce widely tuneable optical radiation. Such a wavelength-selective DBR device may be used in other types of opto-electronic devices, for example, wavelength-selective filters, or wavelength-selective optical detectors. Such devices are particularly useful in WDM network applications where optical sources, wavelength splitters and optical detectors may need to be distributed widely around a building or locality. Because each device can operate across a wide range of wavelengths, there is a reduced need to keep a large number of different types of component in stock. The invention may also permit parts of a WDM network to be reconfigured to different wavelengths without the need to replace components with those designed for a different range of wavelengths.

## Claims

1. A wavelength-selective optoelectronic device (1) comprising a semiconductor substrate (2) and a plurality of semiconductor layers deposited upon the substrate (2) that form a plurality of adjacent distributed Bragg reflector (DBR) components (5A-D), each DBR component (5A-D) having: an elongate optical waveguide (11A-D) for carrying optical radiation (27), each waveguide (11A-D) being spaced laterally from adjacent waveguides with respect to the length of each waveguide (11A-D); and a DBR grating (6) for selecting the wavelength ($\lambda_{A-D}$) of the optical radiation (27) carried by the waveguide (11A-D), the grating (6) having along the length of the waveguide a grating pattern (38) of alternating strips (6A,6B) of varying refractive index, each strip extending at a transverse angle ($\beta$) to the length of the waveguide (11A-D), and the strips (6A,6B) of each grating pattern (38) being aligned with corresponding strips (6A,6B) in each adjacent component; in which the strips (6A,6B) of the DBR components (5A-D) extend at different transverse angles ($\beta_{A-D}$) to corresponding strips (6A,6B) in other DBR components (5A-D) so that the DBR gratings (6) of different DBR components (5A-D) select different wavelengths ($\lambda_{A-D}$).

2. A device (1) as claimed in Claim 1, comprising at least one electrical connection (41,42,43) by which an electrical current may be supplied to the DBR component (5A-D) in order to tune the selected wavelength ($\lambda_{A-D}$).

3. A device (1) as claimed in Claim 1 or Claim 2, in which the transverse angle ($\beta_D$) for the strips (6A,6B) of at least one DBR component (5D) is a right angle.

4. A device (1) as claimed in any preceding claim, in which the waveguides (11A-D) are substantially straight.

5. A device (1) as claimed in any preceding claim, in which the strips (6A,6B) of each grating pattern (38) are aligned substantially parallel with the strips (6A,6B) of other grating patterns (38).

6. A device (1) as claimed in any of Claims 1 to 4, in which the waveguide of each DBR component is substantially parallel with the waveguides of other DBR components.

7. A device (1) as claimed in any preceding claim, in which the semiconductor substrate (2) and a plurality of semiconductor layers (8,10,12,17,18,19,24,26) deposited upon the substrate (2) form additionally at least one semiconductor laser device (3A-D) for generating optical radiation (27), the or each laser device (3A-D) being optically coupled with a corresponding DBR component (5A-D) that selects the wavelength ($\lambda_{A-D}$) of said laser device (3A-D) .

8. A device (1) as claimed in Claim 7, in which there is a plurality of said laser devices (3A-D) optically coupled with corresponding DBR components (5A-D).

9. A device (1) as claimed in any preceding claim, in which the semiconductor substrate (2) and a plurality of semiconductor layers deposited upon the substrate (2) form additionally an optical coupler (16) for coupling together optical radiation (27) entering and/or leaving the optical waveguides (11A-D).

10. A method of forming a wavelength-tuneable optoelectronic device (1) comprising a semiconductor substrate (2) and a plurality of semiconductor layers deposited upon the substrate (2), comprising the steps of:

i) growing on the semiconductor substrate (2) a plurality of semiconductor layers, including at least one layer (110) forming an optical channel for conveying optical radiation (27) ;

ii) creating in at least one layer (112) a distributed Bragg reflector (DBR) pattern (38) having alternating strips (6A,6B) of varying refractive index for selecting the wavelength ($\lambda_{A-D}$) of optical radiation (27) conveyed in said channel (112);

iii) defining in said optical channel (110) a plurality of elongate optical waveguides (11A-D) for guiding optical radiation (27), each waveguide (11A-D) being spaced laterally from adjacent waveguides (11A-D) with respect to the length of each waveguide (11A-D); wherein

the waveguides (11A-D) and DBR pattern (38) are formed so that the strips (6A,6B) cross different waveguides (11A-D) at different angles ($\beta_{A-D}$), so that the strips (6A,6B) select different wavelengths ($\lambda_{A-D}$) in different waveguides (11A-D) .

*Fig. 1*

**Fig. 2**

**Fig. 3**

**European Patent Office**

## EUROPEAN SEARCH REPORT

Application Number

EP 02 25 5800

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 606 573 A (TSANG WON-TIEN) 25 February 1997 (1997-02-25) | 1,10 | G02B6/12 H01S5/0625 |
| Y | * column 3, line 30 - line 35 * * column 5, line 10 - line 15; figure 8 * | 2-9 | |
| Y | KOCH T L ET AL: "PHOTONIC INTEGRATED CIRCUITS" AT & T TECHNICAL JOURNAL, AMERICAN TELEPHONE AND TELEGRAPH CO. NEW YORK, US, vol. 71, no. 1, 1992, pages 63-74, XP000274987 ISSN: 8756-2324 * page 68, column 2; figures 3A,3B * | 2-9 | |
| X | US 5 600 743 A (HILLMER HARTMUT) 4 February 1997 (1997-02-04) * column 5 - column 6; figure 11 * | 1,4-6,10 | |
| X | US 4 309 667 A (PAPUCHON MICHEL ET AL) 5 January 1982 (1982-01-05) * the whole document * | 1,10 | |
| X | PATENT ABSTRACTS OF JAPAN vol. 011, no. 343 (E-555), 10 November 1987 (1987-11-10) & JP 62 124791 A (MATSUSHITA ELECTRIC IND CO LTD), 6 June 1987 (1987-06-06) * abstract * | 1,10 | TECHNICAL FIELDS SEARCHED (Int.Cl.7) H01S G02B |
| A | PATENT ABSTRACTS OF JAPAN vol. 007, no. 136 (E-181), 14 June 1983 (1983-06-14) & JP 58 048981 A (KOGYO GIJUTSUIN;OTHERS: 0J), 23 March 1983 (1983-03-23) * abstract * | 2 | |

-/--

The present search report has been drawn up for all claims

| Place of search | Date of completion of the search | Examiner |
|---|---|---|
| THE HAGUE | 29 July 2003 | Hervé, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 02 25 5800

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | SASAKI T ET AL: "SELECTIVE MOVPE GROWTH AND ITS APPLICATION TO SEMICONDUCTOR PHOTONIC INTEGRATED CIRCUITS" ELECTRONICS & COMMUNICATIONS IN JAPAN, PART II - ELECTRONICS, SCRIPTA TECHNICA. NEW YORK, US, vol. 76, no. 4, 1 April 1993 (1993-04-01), pages 1-11, XP000420772 ISSN: 8756-663X * the whole document * | 2-9 | |
| | | | TECHNICAL FIELDS SEARCHED (Int.Cl.7) |

The present search report has been drawn up for all claims

| Place of search | Date of completion of the search | Examiner |
|---|---|---|
| THE HAGUE | 29 July 2003 | Hervé, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 02 25 5800

This annex lists the patent family members relating to the patent documents cited in the above–mentioned European search report.
The members are as contained in the European Patent Office EDP file on
The European Patent Office is in no way liable for these particulars which are merely given for the purpose of information.

29–07–2003

| Patent document cited in search report | | Publication date | Patent family member(s) | | Publication date |
|---|---|---|---|---|---|
| US 5606573 | A | 25–02–1997 | EP<br>JP | 0641053 A1<br>7154036 A | 01–03–1995<br>16–06–1995 |
| US 5600743 | A | 04–02–1997 | DE<br>EP | 4432410 A1<br>0704946 A1 | 07–03–1996<br>03–04–1996 |
| US 4309667 | A | 05–01–1982 | FR | 2417866 A1 | 14–09–1979 |
| JP 62124791 | A | 06–06–1987 | NONE | | |
| JP 58048981 | A | 23–03–1983 | JP<br>JP | 1395523 C<br>62002478 B | 24–08–1987<br>20–01–1987 |

EPO FORM P0459

For more details about this annex : see Official Journal of the European Patent Office, No. 12/82